# EUROPEAN PATENT SPECIFICATION

(11) **EP 4 484 010 B1**
(45) Date of publication and mention of the grant of the patent: **12.11.2025**
(21) Application number: 24185553.5
(22) Date of filing: 28.06.2024
(51) Int. Cl.: B01L 3/00

(54) **MICROFLUIDIC SYSTEM WITH INTEGRATED SINGLE-MODE OPTICAL FIBER**
MIKROFLUIDISCHES SYSTEM MIT INTEGRIERTER EINMODENGLASFASER
SYSTÈME MICROFLUIDIQUE AVEC FIBRE OPTIQUE MONOMODE INTÉGRÉE

(30) Priority: 28.06.2023 PL 44537623
(43) Date of publication of application: 01.01.2025
(73) Proprietor: Instytut Chemii Fizycznej PAN, 01-224 Warszawa (PL)
(72) Inventor: Kandhadai Vasantham, Shreyas, Warszawa (PL); Kotnala, Abhay, Houston (US); Promovych, Yurii, Wieliszew (PL); Derzsi, Ladislav, Baka (SK)
(74) Representative: JD&P Patent Attorneys Joanna Dargiewicz & Partners

(56) References cited:
- US-A1- 2017 227 440
- US-A1- 2021 016 276

## Description

The subject matter of the invention is a microfluidic system with a built-in single-mode optical fiber, which is used to continuously deliver cells in an aqueous solution to the measurement site (imaging), retain them there for the duration of the measurement (imaging or signal acquisition and processing), and then sort them based on their analyzed signal to one of the output channels.

Current methods of diagnosing leukemia rely on genetic mapping of cells, which is complex, time-consuming and error-prone. Alternative methods have been developed, one of the most promising of which is Raman spectroscopy, offering non-invasive, unique identification of molecules and single cells.

Raman spectroscopy provides detailed information about molecules based on their vibrational states. In standard, so called spontaneous Raman spectroscopy the detectable Raman signal is usually very weak, thus proper detection and identification requires long acquisition times (typically tens of seconds to minutes). To overcome this problem, several improvements to the original method have been developed.

One of the most promising ones, which significantly increases the signal amplification and thus shortens the detection time, is stimulated Raman spectroscopy (SRS). The basic mechanism is reminiscent of spontaneous Raman spectroscopy: a pumping photon with an angular frequency ωₚ that is scattered by a molecule has a small probability of causing some vibrational (or rotational) transition, as opposed to a simple Rayleigh transition. This causes the molecule to emit a photon with a changed frequency. However, SRS, unlike spontaneous Raman spectroscopy, is a third-order nonlinear phenomenon involving a second photon - a Stokes photon with an angular frequency ω_{S} - which stimulates a specific transition. When the frequency difference between both photons (ωₚ - ω_{S} ) resembles a specific vibrational (or rotational) change (ω_{ν} ), the occurrence of this transition is resonantly amplified. In SRS, the signal is equivalent to changes in pump intensity and Stokes beams.

One of the critical requirements for proper acquisition of Raman signals is that the sample remains at rest in the focused pump laser beam (at the detection point). When identifying individual cells that require suspension in a liquid medium, this means that the cells must be held still during the measurement, but without touching the cells or even bringing an external object close to them (which could affect the signal). Non-invasive methods include optical, acoustic or dielectrophoretic trapping. Optical traps proposed and developed by Ashkin in the 1970s have come a long way and have become a common method for manipulating small objects, from single atoms and molecules to particles and living organisms several dozen micrometers in size.

The basic principle of optical tweezers is the transfer of momentum associated with the bending of light. Light (photon) has a momentum that is proportional to its energy and direction of propagation. Any change in the direction of light, due to reflection or refraction, will cause the light's momentum to change. If a transparent dielectric object (e.g. a microparticle or cell) bends the light, changing its momentum, conservation of momentum requires that the object undergo an equal and opposite change in momentum. This creates a force acting on the object.

In a typical configuration of the optical tweezers, the incoming light comes from a laser that has a Gaussian intensity profile (i.e. the light in the center of the beam is brighter than the light at the edges), and the laser beam is focused by a high-quality microscope objective to a location in the plane of the sample. This spot creates an "optical trap" that is able to trap a small molecule inside it.

The sum of forces can be divided into two components: 1. the scattering force, directed in the direction of the incident light and 2. the gradient force, resulting from the gradient of the Gaussian intensity profile and directed in the xy plane towards the center of the beam. The gradient force is the restoring force that pulls the bead inward. If the contribution of the refracted rays to the scattering force is greater than that of the reflected rays, then a restoring force is also created along the z-axis, creating a stable trap.

Commercially available optical tweezers and optical traps rely mainly on focusing and guiding a trapping laser beam through *a microscope objective,* which is bulky and expensive. With advances in the development and application of fiber optics, *fiber optic solutions have been proposed* for tweezing/gripping or moving cells and microparticles with optical forces using either (i) *a single optical fiber,* where the tip of the optical fiber is modified to focus the beam and create an optical trap, *or* (ii) *two mutually opposing optical fibers,* with unmodified tips, which therefore emit a divergent laser beam that "repels" microparticles or cells. Placing two fibers with their tips facing each other and their optical axes aligned creates a double-cone trap.

Accurately aligning the optical axes is crucial, however, because the core of the light-emitting fibers is very small (typically 5-10 µm), so a few micrometers of misalignment can result in the trap not being formed.

For comparison, using commercially available optical tweezers in a typical measurement, a sample (particles, cells or molecules in a liquid medium) is placed on a microscope slide (optionally covered with a coverslip) and the particles of interest are captured by moving the microscope stage relative to the laser beam which is perpendicular to the plane glass slide (microscope stage).

With available optical tweezers that use microfluidic techniques and flow control, the sample can be brought to the detection point (in the x direction). However, in such systems, optical fibers are arranged perpendicular to the direction of flow (y direction), and observation/detection by the microscope takes place along the z axis. The solution we propose consisting in delivering cells (or other microscopic objects) to the detection point one by one, catching them and keeping them there for any time (for the duration of signal acquisition), and then releasing and sorting them (e.g. based on the acquired and analyzed SRS signal) is innovative and unique by (i) laying a single single-mode optical fiber with an unmodified tip (only cut straight ) parallel to the flow and with the tip pointing against the flow, and consequently (ii) by trapping and manipulating cells or other micron-sized objects), namely by balancing the optical radiation pressure (more precisely, the optical scattering force of a divergent single-mode Gaussian beam) and the hydrodynamic pressure (i.e. the drag force of the viscous liquid in which the cells or microparticles are suspended) in the microchannels.

From the publication *Intelligent image-activated cell sorting 2.0* (Akihiro Isozaki et al., Lab Chip, 2020), a microfluidic system is known, which is used for continuous analysis of biological cells without retaining them in a microfluidic channel, and then separating them using local flow control by hydrodynamic pumps.

The publication *Microfluidic device for continuous single cell analysis via Raman spectroscopy enhanced by integrated plasmonic nanodimers* (Gerardo Perozziello, Patrizio Candeloro, Antonio De Grazia et al., Optics Express, 2016) describes a microfluidic system for continuous analysis of cells using Raman spectroscopy, a technique in which biological cells are delivered to the measurement site through a microfluidic channel, and the cells are stopped for the duration of the measurement by blocking the channel with a cell at the point of narrowing the channel, and the channel itself has one input for the cell, one input and one output.

In the publication *Flow-dependent optofluidic particle trapping and circulation,* (Thomas Blakely, Reuven Gordon and David Sinton, Lab Chip, 2008) they describe planar microfluidic systems with built-in optical fibers for trapping particles in the channel of the microfluidic system, which is constructed in such a way that the optical fiber is located in the plane of the microfluidic channel, and the flow of particles is directed in the direction opposite to the scattering forces of light supplied to the system by the optical fiber. At the same time, optical fibers with lenses made at the ends and cut at right angles are used to trap and hold the cells. The use of the latter solution is technically simpler, but due to the smaller optical force gradient, the particles must be delivered to the optical tweezers as close to its optical axis as possible.

To maximize the number of captured cells, it is necessary to focus them at the center of the cross-section of the microfluidic channel. A method of focusing cells in a single-layer microfluidic channel is known from the publication *Universally applicable three-dimensional hydrodynamic focusing in a single-layer channel for single cell analysis (*Yingying Zhao, Qin Li, Xiaoming Hu, Analytical Methods, 2018*).*

The Chinese patent CN110918142B presents a device in which the direction of flow can be selectively controlled by deforming the surface of microfluidic elements.

In contrast, US patent US11512691B2 relates to a microfluidic system in which the components of a fluid mixture in a sample are directed and isolated by two-step focusing, in which the sheath fluids compress the fluid mixture in the sample input channel in one direction so that the fluid mixture becomes a narrower stream confined by the sheath fluids, and by compressing the fluid mixture in a second direction, further downwards, so that the components are compressed and directed in the selected direction to pass through the chamber for analysis as a single set for identification and separation by various methods. Another US patent US11446665 describes a microfluidic system having a microchannel for sample processing. The microchannel can focus the sample using a focusing fluid and geometry that creates a core stream. The core stream formation geometry may include a lateral fluid-concentrating element and one or more vertical fluid-concentrating elements. A microfluidic system may contain multiple microchannels operating in parallel on the microfluidic system.

US patent application US20060171846A1 discloses a microfluidic system containing integrated optical waveguides that can be used to optically trap particles such as cells flowing through the system. The waveguides in these systems can be arranged to create optical traps that can be used to power pumps and valves in microfluidic systems, to capture and analyze particles in these systems, and to sort captured particles into various microfluidic flow channels. Another US patent application US20090239250A1 describes a method for analyzing and obtaining reliable data on the plasma membrane of single cells using a microfluidic cell analyzer. The microfluidic cell analyzer of the invention consists of a single cell trap, a manipulator set to manipulate the outer surface of the cell in the trap, a detection zone in communication with the single cell trap, and a detector. Another US patent application US20140220557A1 presents a device and method for separating particles. The device includes at least one collimated light source that can generate at least one collimated light beam. The device further includes a first channel in the first plane and a focused particle stream nozzle operatively coupled to the first channel. The device also includes a second channel in a second plane orthogonal to the first plane. The second channel communicates with the first channel. The second channel has a second cross-section. The second channel is oriented to receive the collimated beam of the light source. The device further includes a third channel in a third plane orthogonal to the second plane. The third channel communicates with the second channel. The collimated beam of the light source is oriented to enter the cross-section of the first channel, then pass through the second channel, and then enter the cross-section of the third channel.

US2021/016276A1 describes a further microfluidic system with a hydrodynamic spatial focusing module and a sorting module.

In summary, among solutions known from the state of the art, the most common approach is the use of a microscope set in which two lenses are used to *align* laser beams and create an optical trap. However, in fiber optic solutions, a common approach is one of the following:
- using two fibers with opposite tips to create a *"dual-cone"* optical trap;
- when only one fiber is used, the tip of the fiber is usually modified to pull the cell rather than push it. Typical fiber modifications include: tapering the fiber or nanoprinting optical elements at its tip (e.g. a Fresnel lens).

It would therefore be necessary to provide a microfluidic system in which it would not be necessary to focus the laser beam through microscope lenses, and would also use a single optical fiber without modifications such as narrowing, etching, printing or other modifications known from the state of the art.

The subject matter of the invention is a microfluidic system with an integrated single-mode optical fiber containing a hydrodynamic spatial focusing module, a sorting module, while the integrated optical fiber together with a part of the main channel form an opto-hydrodinamic trap module, wherein the hydrodynamic spatial focusing module contains a main channel, which channel has a first end and a second end, the first end of the main channel includes inlets for introducing sheath liquid and an inlet for introducing sample liquid, wherein the inlets are oriented (with respect to the main channel) at right angles, and the sample liquid introduction inlet is located between the sheath liquid introduction inlets, and the sheath liquid introduction inlets communicate with the first end of the main channel through the first side channels, and the second end of the main channel is connected to the outlets through the output channels, and between the first and the second end of the main channel there is a sorting module, and at the other end of the main channel an optical fiber channel is connected between the output channels for the introduction of optical fiber, defining a detection zone.

In a preferred embodiment of the invention, the side channels and the output channels connect to the main channel at an angle of 30° to 150°.

In a further preferred embodiment of the invention, the side channels connect to the main channel at an angle of 30° to 50°.

In another preferred embodiment of the invention, the output channels connect to the main channel at an angle of 130° to 150°.

In yet another preferred embodiment of the invention, the connection of the side channels and output channels with the main channel is Y-shaped.

In a preferred embodiment of the invention, the diameter of the optical fiber channel corresponds to the diameter of the single-mode optical fiber.

In a preferred embodiment of the invention, the optical fiber is directed with its end towards the main channel, and its optical axis is aligned with the center of the main channel.

In a preferred embodiment of the invention, the tip of the single-mode optical fiber is cut at a right angle and is not etched, drawn (tapered) or does not contain microfabricated elements.

In a preferred embodiment of the invention, the microfluidic device is made of optically transparent and biocompatible materials - polydimethylsiloxane, glass, polycarbonate, polymethyl methacrylate or a combination thereof.

In another preferred embodiment of the invention, a sorting module is placed directly behind the detection zone.

In yet another preferred embodiment of the invention, the ratio of the lengths of the output channels is 1:3.

In yet another embodiment of the invention, the sorter module is selected from the group comprising a dielectrophoretic, push-pull, optical or acoustic sorter, preferably optical.

The solution according to the invention is characterized by a specific arrangement of the optical fiber in relation to the flow field, as well as in relation to the direction of signal acquisition, in particular the optical fiber in the microchannel is placed parallel to the flow, with its straight cut end directed in the direction opposite to the flow and with its core (usually 5-10 µm) emitting a laser beam positioned in the center of the microchannel, where the shear stress acting on the cells is minimal and the flow velocity is the highest. This means that focusing the laser beam through microscope lenses (the most common approach to creating optical tweezers and traps) is not required, which significantly increases the mobility of the system while reducing its complexity, weight and cost.

Additionally, the microfluidic system according to the invention uses a single optical fiber to guide the laser beam instead of two optical fibers with tips directed at each other. Another important feature is that the fiber tip does not need to be tapered, etched, printed or otherwise modified beyond standard slitting and straight cutting.

The action (trapping) is based on the balance between the optical scattering forces of the divergent laser beam and the hydrodynamic drag force of the liquid stream carrying particles, droplets or cells. It enables the capture/immobilization and sorting of microscopic objects with a diameter of up to several tens of micrometers and the manipulation of captured objects along the optical path in the range of several hundred micrometers (depending on the optical properties of the particles, the liquid flow speed in the microchannels and the laser power used). Despite its simplicity, the presented invention, as mentioned above, allows for precise control of the position of the trap (together with the trapped cells or microparticles) by externally changing the output power of the trapping laser and also by changing the sample flow rate in the microchannels without the need to move the microscope stage or the detection module (lens + camera).

For comparison, in all other optical tweezers based on microscope objectives presented in the available literature, the position of the trap can only be changed by mechanically moving the microscope objective or the stage. Also, in known single optical fiber solutions, modification of the optical fiber tip is necessary, and none of the single or dual optical fiber approaches allow the dual control of the optical trap position described above (i.e., by changing the laser power or changing the flow rate in the microchannels).

The microfluidic system itself (network of channels) is arranged horizontally, making it compatible with most optical bright-field, phase-contrast or fluorescence microscopes, and stereoscopes.

The microfluidic system is made of optically transparent and biocompatible materials - poly(dimethylsiloxane) PDMS, glass, polycarbonate, PMMA or a combination thereof.

The purpose of the invention is to provide a continuous sequence of 3 operations on each cell or particle in a non-invasive manner (i.e. without physical contact) and with high accuracy, namely:
i) delivering cells (or other micro-objects) one by one in a microchannel along a defined path to the detection zone/point
ii) immobilizing the cell/particle at that point with high precision (not allowing the cell/particle to move more than 2 µm from that position) and for any length of time, e.g., the time needed to collect signals from the trapped cell/particle at an intensity sufficient for its identification/classification (in the case of spontaneous Raman spectroscopy it may take up to several dozen seconds)
iii) after successful signal acquisition, releasing the immobilized cell/particle and sorting it to one of the output channels.

The proposed solution is illustrated in the figures:
Fig. 1a. A schematic drawing (three-dimensional representation) of the invention, showing individual parts of the invention.
Fig. 1b. Exploded view of the invention, showing individual modules (consisting of several parts).

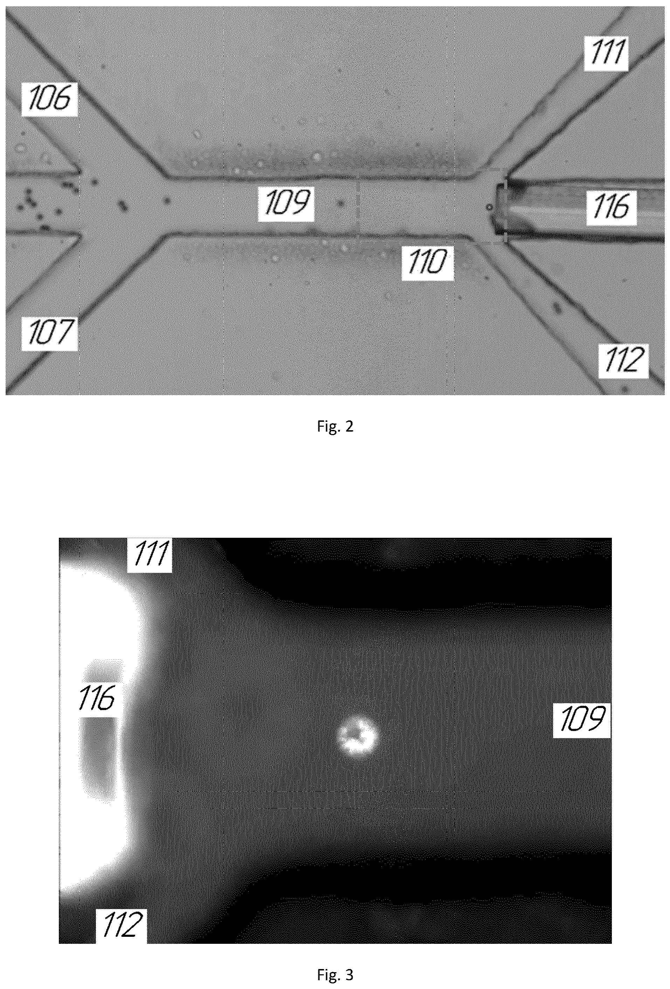

Fig. 2. Microphotograph of the system (top view) during operation, showing the immobilized HeLa-60 cell in an opto-hydrodynamic trap (on the right), in close proximity to the tip of the built-in optical fiber.
Fig. 3. Close-up of an immobilized HeLa-60 cell in an opto-hydrodynamic trap.
Fig. 4. Optical energy profile at the output of the trap fiber.
Fig. 5. Micrographs showing the universality of the opto-hydrodynamic trap. Optical image of a single (a) 5 µm polystyrene particle, (b) 15 µm polystyrene particle, (c) 5 µm yeast cell, (d) 30 µm THP cell - all while trapped in an opto-hydrodynamic trap.

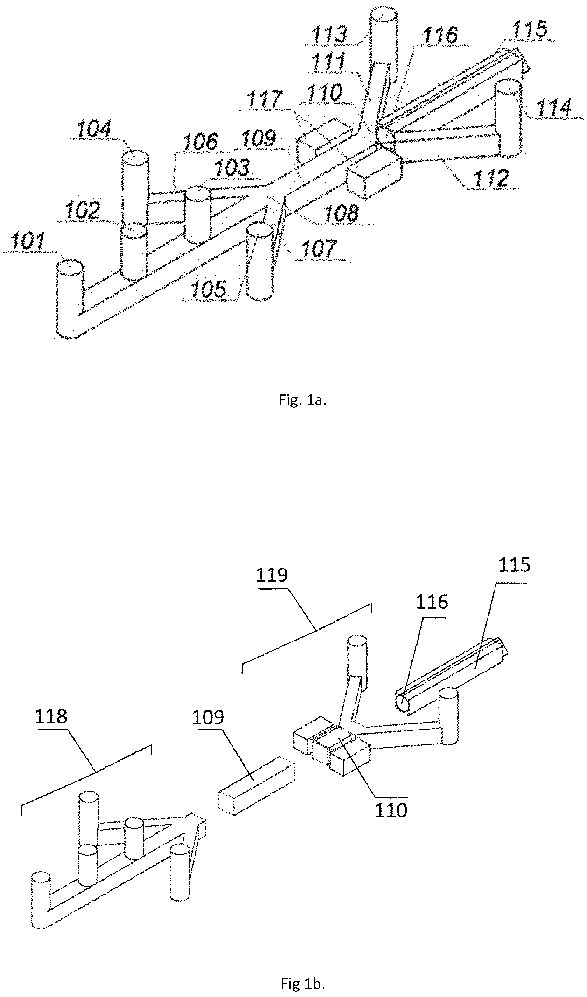

The microfluidic system according to the invention consists of three main modules (Fig 1b):
i) hydrodynamic spatial focusing module (118) - responsible for focusing cells or microparticles suspended in a carrier liquid in a narrow stream and delivering them to the detection zone
ii) opto-hydrodynamic trap module, consisting of a channel for inserting the fiber (116), the single-mode fiber itself (116) and the lower part of the main channel (109) - responsible for capturing (trapping) the delivered cells or microparticles and keeping them in place for detection/scanning time
iii) sorting module (119) - responsible for separating interesting cells/microparticles from the rest of the cells/microparticles after scanning and based on the analyzed signal.

### Spatial hydrodynamic focusing (118)

The principle of spatial hydrodynamic focusing is based on the relative volume flow rates of the sample liquid and sheath liquids. Additionally, very small channel dimensions and low flow velocities result in a very low Reynolds number (Re << 1), which means that the flow is laminar. In other words, liquids do not mix by convection, but infinitely thin (thickness of the order of atoms) layers of liquid slide one after another (or next to each other) like sheets of paper.

In a preferred embodiment of the invention, the sample liquid (cell or particle suspension) is introduced into the microchannels through the inlet (102) and the sheath/focusing liquids are introduced through the inlets (101), (103), (104) and (105), while the invention is characterized by the angle between the inlet channels (106, 107) and the main channel (109) ranging from 30° to 60°. Sheath liquids introduced through inlet ports (101) and (103) concentrate the sample liquid stream by compressing it vertically. The presented order of liquid introduction (lower sheath liquid - particle/cell suspension - upper sheath liquid) results in a 3-layer co-flowing liquid stream with the suspension flowing in the middle. The relative thickness of the individual liquids in the microchannel is directly proportional to the volumetric flow rate at which they are introduced into the microchannels. The sheath streams introduced through the inlet ports (104) and (105) combine with the generated three-layer liquid stream at the junction (108) and concentrate it by horizontal compression. The sample liquid stream after such focusing can be several micrometers wide and thick, so that the cells in the sample liquid flow in a narrow trajectory in the center of the main channel (109) and can be delivered to the detection point (110) with high precision.

Sheath liquids can be introduced into the microchannels through individual inlets (101), (103), (104), and (105) independently of each other using high-precision low-pressure syringe pumps (preferred method) or dedicated pressure regulators. The diameter of the focused sample liquid stream (suspension of cells or microparticles) and the position of this stream in the main channel (thus the speed and trajectory of individual cells or microparticles) can be precisely controlled by the relative flow rates between the sample liquid and the sheath liquids.

Example: if we want to obtain the positioning of cells with a diameter of approximately 12 µm in the cross-sectional plane with an accuracy of ± 1 µm, it is enough for the cross-sectional diameter of the sample liquid stream to be approximately 6 µm. For this purpose, the ratio of the volume flow rate of the cell suspension (from the inlet port 102) to the sheath fluids fed from the inlet ports (101, 103, 104 and 105) should be 1:12.

### Main channel (109)

The height of the main channel (109) is typically determined by the diameter of the optical fiber (106) that we insert in front of the focused stream. For example, using a standard single-mode optical fiber with a cut diameter of 125 µm, the height of the microfluidic channels is also 125 µm. This allows the fiber core (and therefore the emitted laser beam) to be precisely positioned and aligned with the geometric center of the main channel (and therefore with the narrow focused stream of cells or microparticles) without the need to use micrometer positioning screws or other complex devices for further alignment. The width of the main channel (109) is preferably the same as the height to enable isometric focusing. The length of the main channel (109) is typically between 250 µm and 1500 µm (although it can be as long as 5 cm), and it branches symmetrically, in a Y shape, into two output channels (111) and (112).

### Detection zone (110)

The detection zone (110) is located in close proximity, i.e. at a distance of 5 µm to 250 µm, from the branching point at the other end of the main channel (109).

After delivering the cells or particles to the detection zone (110), they should be immobilized in the microfluidic channel in such a way that the center of the cell/particle does not move away from the selected (trapping) point further than ± 2 µm. This allows for sensitive and long-term measurement/analysis.

### Optical fiber and hydro-optic trap

Between the two output channels (111) and (112), as a continuation of the main channel (109), there is a third channel (115) into which a single-mode optical fiber (116) is inserted, the tip of which is few micrometers (5-250 µm) down from the detection zone (110) (and the branch point) directed upstream. The optical fiber together with the lower part of the main channel (109), the detection zone and the Y-connector form the trapping module.

In a preferred embodiment of the invention, a single-mode optical fiber (116) with a diameter of 125 µm is embedded in the device with a tip cut at a right angle and directed against the flow, and the optical path of the emitted laser beam is aligned with the center of the main channel, and therefore with the stream of focused cells or particles.

To facilitate the introduction of the optical fiber (116) into the closed microchannel (115), the deposition channel (115) begins at the input side with a width of approximately 2 times wider than the width of the optical fiber, then gradually narrows, reaching the final width (equal to the diameter of the optical fiber) at a distance ca. 500 µm from the Y-connector (not shown). After inserting the optical fiber (116) into the channel (115) and setting its tip in the appropriate position, the channel (115) is sealed with light-curing UV glue with an appropriately selected viscosity.

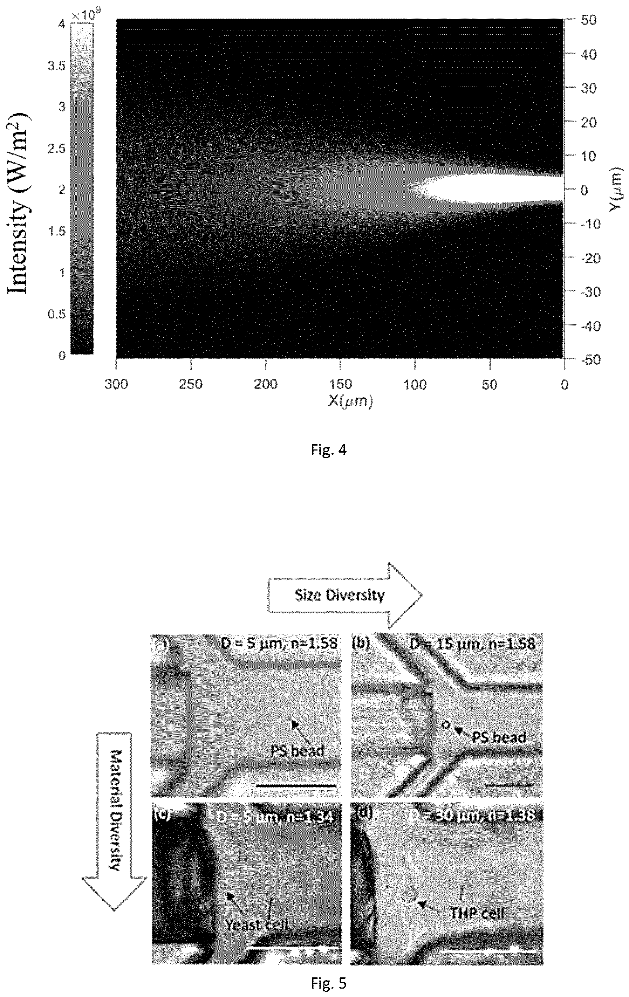

During operation, a laser beam with a wavelength *λ* = 973 nm, a maximum optical power of 550 mW is emitted through the built-in optical fiber in front of the main channel and has a Gaussian profile (radiation is limited to the basic (TEM₀₀) Gaussian mode). The optical energy propagation profile in the water-filled microfluidic channel is shown in Fig. 4.

Cells or molecules are pushed by the hydrodynamic drag of the viscous liquid towards the tip of the optical fiber, which emits a Gaussian laser beam. The emitted Gaussian beam exerts a radiation pressure on the cells or particles as they flow towards the tip of the optical fiber, and with the scattering optical force being the dominant contributor, the beam pushes the cells away from the tip in the direction opposite to the flow. As the laser beam spreads, it loses its energy with distance from the fiber tip, and at some distance the optical scattering force on the cells equals the viscous drag force, at which point the cell stops and remains stationary (i.e., becomes trapped). The position of this opto-hydrodynamic trap can be changed along the laser optical path by changing the volumetric flow rates (or applied external pressure) of the liquid or by changing the laser output power.

At the beginning of the optical trap operation, the sample and sheath liquid flow rates are set and the laser power is experimentally adjusted so that the trap is created at the most convenient point for imaging and signal acquisition.

To minimize cell damage as shown, the total volume flow rate (sum of flow rates from inlets 102, 102, 103, 104 and 105) should not exceed 130 µL/h. Higher flow rates result in drag greater than what can be effectively compensated by the laser beam without damaging the cells.

### Sorting module (119)

The main channel (109) branches symmetrically, Y-shaped, into two output channels (111) and (112), which end in output ports (113) and (114) to which small plastic or glass containers are attached using flexible Teflon tubing (not shown) to collect properly sorted cells and waste. In front of the main channel connector (109) with the two outlet channels (111) and (112), mounted on either side of the main channel is any type of deflection or attraction/repulsion mechanism (117), which together with the two output channels (111) and (112), outlet ports (113) and (114), and collection containers (not shown) constitute the sorting module of the microfluidic system. The angle between the microfluidic channels (111, 112) and the main channel (109) is 130° to 150°. The sorter can be of any type, e.g. dielectrophoretic, push-pull, optical, acoustic (to mention only the most known types in the state of the art), and according to which the appropriate mechanism (117) is integrated with the microfluidic system, deflecting cells/molecules from the center of the main channel and directing them to the selected outlet channel. It must either push or pull the already trapped cell with sufficient force to move it from the center of channel (109) towards one (selected) of the output channels.

The solution according to the invention uses an optical sorter in which the second optical fiber is integrated perpendicularly with its core aligned with the trapping position. By default, the output channels have little difference in hydrodynamic resistance, and cells (without external force acting on them) flow into the sorting channel closer to the second (sorting) fiber. These are waste (non-essential cells). However, if the cell is analyzed as positive after capture and detection, then a short pulse of the laser beam is radiated from the sorting fiber, which pushes the cell into the second sorting channel.

The preferred example configuration allows for cell sorting combined with real-time analysis. For this purpose, on both sides of the optical fiber tip (116) there are two separate inlet channels (111 and 112), in which the flow is regulated by changing the hydrostatic pressure (changing the vertical position of the collecting containers). The sorter "actuator/trigger" (117) selectively forces cells into one of the channels (111, 112) by means of dielectrophoresis, electrophoresis, electroosmosis, optical scattering energy, local flow variation, standing acoustic waves, magnetism, or hydrostatic forces.

The solution according to the invention includes i) a microfluidic device with multiple inlets and outlets, ii) with a built-in single-mode optical fiber and iii) a sorting module. The microfluidic device has multiple inlet ports (5 are preferred in the version shown) that merge downstream into one common channel (referred to as the main channel or detection channel), which then branches out again into several outlet channels (2 are preferred in the version shown). The suspension (cells or microparticles in the aqueous phase) is introduced from a sterile reservoir or syringe through flexible polymer tubing (PE, PFTE, silicone or similar) through a specific inlet port, and sheath liquids (saline solution, water or cell culture medium) are introduced through the remaining 4 inlet ports. The detection point where cells and particles are trapped/immobilized is located at/or near the branch point, i.e. where a single main channel branches into several output channels (sorting channels). The output channels end in outlet ports, each of which is connected via flexible tubing (preferably made of Teflon) to a small container or vial. The continuation of the main channel beyond the branch point is not considered an output channel, instead it is used to embed a single-mode optical fiber that is used to generate an opto-hydrodynamic trap for immobilizing cells and particles. The flow in a microfluidic device can be actuated and controlled, for example, by low-pressure, high-precision syringe pumps or by a pressure regulator.

### Example 1

To verify the relevance and performance of the hydrodynamic spatial focusing module and trapping capabilities, a 3-stage proof-of-concept experiment was performed.

First, an aqueous solution of polystyrene particles with a diameter of 15 µm, at a concentration of 0.02% w/v, was introduced into the microfluidic device through the sample inlet (102), without the use of sheath liquids, through inlets 101, 103, 104, 105. The polystyrene particles flowed randomly throughout the entire cross-section of the channel, which resulted in a poor capture efficiency of 5%. The poor capture efficiency in this case is because the particles flow randomly and only a few particles that are aligned with the optical axis of the fiber are trapped.

In the next step, the particle trajectories were spatially constrained in the Y direction, i.e. along the width of the channel, by slowly increasing the side shield liquid flow rate through inlets 104 and 105. The sheath to sample flow rates were adjusted to the ratio 5:1, for which the particle trajectories coincided with the optical axis of the optical fiber in the Y direction. We have now observed a capture efficiency of 35%, which is due to the facts that all particles were aligned with the fiber core in the Y direction, but only a fraction of them were in the correct position along the Z direction, i.e. along the height of the channel.

To further increase the capture efficiency, both the upper and lower sheath liquid flow through inlets 101 and 103 were continuously increased so that particles were also confined in the Z direction and completely aligned with the optical axis of the optical fiber, resulting in continuous capture of particles with an efficiency of over 70%. In each case, particles were captured by opto-hydrodynamic tweezers and held for >2 seconds before release. To achieve 100% capture efficiency, all particles flowing in the channel must be aligned with the optical axis with high precision. This requires very high flow velocities in the sheath, which results in high drag forces that cannot be balanced by optical scattering forces in the system of the invention.

### Example 2

The invention enables a wide range of materials, sizes and morphologies to be delivered to the detection point, captured, released and sorted. As long as sufficient dispersive forces can be exerted on the particles, greater than the hydrodynamic drag force, it is possible to trap microscopic objects using the invention. We demonstrated the versatility of the invention by hydrodynamically focusing, capturing and sorting i) polystyrene particles with a diameter of 5 µm and 15 µm, ii) single mammalian cells, such as leukemia cells (THP-1) in the size range of 10-30 µm, as well as iii) microorganisms such as *Saccharomyces cerevisiae* yeast cells 3-5 µm in size. The results are summarized in Fig. 5.

However, particles with smaller sizes, such as polystyrene beads smaller than 1 µm and bacterial *E. coli* cells (1-2 µm), could not be stably trapped due to the relatively small optical scattering and gradient forces acting on them compared to hydrodynamic drag force, even at minimum flow speed. Our demonstrations clearly show the broad application of OHT, including single-cell studies in a fully Lab-On-A-Chip format.

### Example 3

The microfluidic system can be used even without a sorting module, using only focusing-delivering modules. And the trapping invention can be used, for example, in Raman spectroscopy to obtain/generate libraries of signals and spectra along with optical images of various types of cells, which may be invaluable in the early detection of cancer or other types of diseases.

The sample inlets and sheath liquid inlets were connected to glass syringes (Hamilton, USA, volume 0.5 ml) using flexible Teflon tubing (ID/OD = 0.5/1.0 mm) and the flow was controlled by precise low-pressure syringe pumps (Nemesys, Cetoni, Germany). We used human leukemia cells, mixed with healthy white blood cells in a 1:4 ratio and suspended in a PBS buffer solution at a concentration of 5 x 10⁵ cells/ml.

Cells guided into the microfluidic system were focused in the carrier liquid in a narrow stream by spatial hydrodynamic focusing using pure PBS solution (without cells) as sheath liquids, supplied from inlets 101, 103, 104, 105 at flow rate ratios of 1:5 and 1:12 for horizontal and vertical sheath liquids, respectively. The microfluidic chip was placed on a stage of a stimulated Raman spectroscope (SRS), built by modifying an inverted fluorescence microscope (Nikon Eclipse Ti2). Cells were directed to the detection point, captured using opto-hydrodynamic traps and held for a period of 3-8 s while the SRS signal with a wavelength of 2940 cm⁻¹ was collected, after which the cells were released and sorted by an optical sorting module based on optical fiber integrated with a microfluidic chip. The optical sorter was simply another optical fiber of the same type as the trapping laser, but placed perpendicularly to the main channel (and therefore to the trapping fiber) with the tip pointing toward the detection point.

After initially releasing the cell from the opto-hydrodynamic traps, by turning off the trapping laser, a short pulse from the 500 mW sorting laser was applied, which reflected the cells away from the center of the channel and directed them to the output channel that was further away from the sorting laser.

## Claims

1. A microfluidic system with an integrated single-mode optical fiber (116) containing a hydrodynamic spatial focusing module, a sorting module, wherein the hydrodynamic spatial focusing module (118) contains a main channel (109), which channel has a first end and a second end, the first end of the main channel (109) includes inlets for introducing sheath liquid (101, 103, 104, 105) and an inlet for introducing sample liquid (102), wherein the inlets (101, 102, 103, 104, 105) are oriented with respect to the main channel (109) at right angles , and the sample liquid introduction inlet (102) is located between the sheath liquid introduction inlets (101, 103), and the sheath liquid introduction inlets (104, 105) communicate with the first end of the main channel (108) through the first side channels (106, 107), and the second end of the main channel (109) is connected to the outlets (113, 114) through the output channels (111, 112), and between the first and the second end of the main channel (109) there is a sorting module (119),
the microfluidic system being **characterised in that** at the other end of the main channel (109), an optical fiber channel (115) is connected between the output channels (111, 112) for the introduction of the single-mode optical fiber (116), defining a detection zone (110),

2. The system according to claim 1, **characterized in that** the side channels (106, 107) and the output channels (111, 112) connect to the main channel (109) at an angle of 30° to 150°.

3. The system according to claim 1 or 2, **characterized in that** the side channels connect to the main channel (109) at an angle of 30° to 50°.

4. The system according to claim 1 or 2, **characterized in that** the output channels (111, 112) connect with the main channel (109) at an angle of 130°to 150°.

5. The system according to any of the preceding claims, **characterized in that** the connection of the side channels (106, 107) and the output channels (111, 112) with the main channel (109) is Y-shaped.

6. The system according to claim 1, **characterized in that** the diameter of the optical fiber channel (115) corresponds to the diameter of the single-mode optical fiber (116).

7. The system according to claim 1 or 6, **characterized in that** the optical fiber (116) is directed with its end towards the main channel (109) and its optical axis is aligned with the center of the main channel (109).

8. The system according to claim 1, 6 or 7, **characterized in that** the tip of the single-mode optical fiber (116) is cut at a right angle and is not etched, drawn (tapered), or does not contain microfabricated elements.

9. The system according to any of the preceding claims, **characterized in that** it is made of optically transparent and biocompatible materials - polydimethylsiloxane, glass, polycarbonate, polymethyl methacrylate - or a combination thereof.

10. System according to claim 1, **characterized in that** a sorter module (119) is placed directly behind the detection zone (110).

11. The system according to claim 1 to 5, **characterized in that** the ratio of the lengths of the output channels is 1:3.

12. The system according to claim 11, **characterized in that** the sorting module is selected from the group comprising a dielectrophoretic, push-pull, optical or acoustic sorter, preferably optical.

## Patentansprüche

1. Ein mikrofluidisches System mit einer integrierten Singlemode-Lichtleitfaser (116), die ein hydrodynamisches Raumfokussierungsmodul und ein Sortiermodul enthält, wobei das hydrodynamische Raumfokussierungsmodul (118) einen Hauptkanal (109) enthält, der ein erstes und ein zweites Ende aufweist, und das erste Ende des Hauptkanals (109) Einlässe zur Zufuhr von Hüllflüssigkeit (101, 103, 104, 105) und einen Einlass zur Zufuhr von Probenflüssigkeit (102) umfasst, wobei die Einlässe (101, 102, 103, 104, 105) rechtwinklig zum Hauptkanal (109) ausgerichtet sind, und der Einlass zur Zufuhr von Probenflüssigkeit (102) sich zwischen den Einlässen zur Zufuhr von Hüllflüssigkeit (101, 103) befindet, und die Einlässe zur Zufuhr von Hüllflüssigkeit (104, 105) über die ersten Nebenkanäle (106, 107) mit dem ersten Ende des Hauptkanals (108) verbunden sind, und das zweite Ende des Hauptkanals (109) über die Ausgangskanäle (111, 112) mit den Auslässen (113, 114) verbunden ist, und zwischen dem ersten und dem zweiten Ende des Hauptkanals (109) sich ein Sortiermodul (119) befindet, wobei das mikrofluidische System **dadurch gekennzeichnet ist, dass** am anderen Ende des Hauptkanals (109) ein Glasfaserkanal (115) zwischen den Ausgangskanälen (111, 112) angeschlossen ist, der die Singlemode-Lichtleitfaser (116) einführt und eine Detektionszone (110) definiert.

2. Das System nach Anspruch 1, **dadurch gekennzeichnet, dass** die Nebenkanäle (106, 107) und die Ausgangskanäle (111, 112) in einem Winkel von 30° bis 150° mit dem Hauptkanal (109) verbunden sind.

3. System nach Anspruch 1 oder 2, **dadurch gekennzeichnet, dass** die Nebenkanäle in einem Winkel von 30° bis 50° mit dem Hauptkanal (109) verbunden sind.

4. System nach Anspruch 1 oder 2, **dadurch gekennzeichnet, dass** die Ausgangskanäle (111, 112) in einem Winkel von 130° bis 150° mit dem Hauptkanal (109) verbunden sind.

5. System nach einem der vorhergehenden Ansprüche, **dadurch gekennzeichnet, dass** die Verbindung der Nebenkanäle (106, 107) und der Ausgangskanäle (111, 112) mit dem Hauptkanal (109) Y-förmig ist.

6. System nach Anspruch 1, **dadurch gekennzeichnet, dass** der Durchmesser des Lichtleitfaserkanals (115) dem Durchmesser der Singlemode-Lichtleitfaser (116) entspricht.

7. System nach Anspruch 1 oder 6, **dadurch gekennzeichnet, dass** die Lichtleitfaser (116) mit ihrem Ende zum Hauptkanal (109) gerichtet ist und ihre optische Achse mit der Mitte des Hauptkanals (109) ausgerichtet ist.

8. System nach Anspruch 1, 6 oder 7, **dadurch gekennzeichnet, dass** die Spitze der Singlemode-Lichtleitfaser (116) rechtwinklig abgeschnitten ist und nicht geätzt, gezogen (verjüngt) ist, oder keine mikrofabrizierten Elemente enthält.

9. System nach einem der vorhergehenden Ansprüche, **dadurch gekennzeichnet, dass** es aus optisch transparenten und biokompatiblen Materialien (Polydimethylsiloxan, Glas, Polycarbonat, Polymethylmethacrylat) oder aus einer Kombination davon besteht.

10. System nach Anspruch 1, **dadurch gekennzeichnet, dass** ein Sortiermodul (119) direkt hinter der Detektionszone (110) platziert ist.

11. System nach Anspruch 1 bis 5, **dadurch gekennzeichnet, dass** das Längenverhältnis der Ausgangskanäle 1:3 beträgt.

12. System nach Anspruch 11, **dadurch gekennzeichnet, dass** das Sortiermodul aus der Gruppe ausgewählt ist, die einen dielektrophoretischen, 'push-pull'-, optischen oder akustischen Sortierer, vorzugsweise einen optischen Sortierer, umfasst.

## Revendications

1. Système microfluidique à fibre optique monomode intégrée (116) contenant un module de focalisation spatiale hydrodynamique et un module de tri, dans lequel le module de focalisation spatiale hydrodynamique (118) comprend un canal principal (109) ayant une première et une seconde extrémité et la première extrémité du canal principal (109) comprend des entrées pour l'introduction du liquide de gaine (101, 103, 104, 105) et une entrée pour l'introduction du liquide d'échantillon (102), dans lequel les entrées (101, 102, 103, 104, 105) sont orientées à angle droit par rapport au canal principal (109) et l'entrée d'introduction du liquide d'échantillon (102) est située entre les entrées d'introduction du liquide de gaine (101, 103) et les entrées d'introduction du liquide de gaine (104, 105) communiquent avec la première extrémité du canal principal (108) par les premiers canaux latéraux (106, 107), et la seconde extrémité du canal principal (109) est reliée aux sorties (113, 114) par les canaux de sortie (111, 112), et entre les première et seconde extrémités du canal principal (109) se trouve un module de tri (119), et le système microfluidique est **caractérisé en ce qu'**à l'autre extrémité du canal principal (109), un canal de fibre optique (115) est connecté entre les canaux de sortie (111, 112) pour l'introduction de la fibre optique monomode (116), définissant une zone de détection (110).

2. Système selon la revendication 1, **caractérisé en ce que** les canaux latéraux (106, 107) et les canaux de sortie (111, 112) sont reliés au canal principal (109) à un angle de 30° à 150°.

3. Système selon la revendication 1 ou 2, **caractérisé en ce que** les canaux latéraux sont reliés au canal principal (109) à un angle de 30° à 50°.

4. Système selon la revendication 1 ou 2, **caractérisé en ce que** les canaux de sortie (111, 112) sont reliés au canal principal (109) à un angle de 130° à 150°.

5. Système selon l'une quelconque des revendications précédentes, **caractérisé en ce que** la connexion des canaux latéraux (106, 107) et des canaux de sortie (111, 112) au canal principal (109) est en forme de Y.

6. Système selon la revendication 1, **caractérisé en ce que** le diamètre du canal de fibre optique (115) correspond au diamètre de la fibre optique monomode (116).

7. Système selon la revendication 1 ou 6, **caractérisé en ce que** la fibre optique (116) est orientée avec son extrémité vers le canal principal (109) et son axe optique est aligné avec le centre du canal principal (109).

8. Système selon la revendication 1, 6 ou 7, **caractérisé en ce que** l'extrémité de la fibre optique monomode (116) est coupée à angle droit et n'est ni gravée, ni étirée (effilée), ou ne contient pas d'éléments microfabriqués.

9. Système selon l'une quelconque des revendications précédentes, **caractérisé en ce qu'**il est constitué de matériaux optiquement transparents et biocompatibles (polydiméthylsiloxane, verre, polycarbonate, polyméthacrylate de méthyle) ou d'une combinaison de ceux-ci.

10. Système selon la revendication 1, **caractérisé en ce qu'**un module de tri (119) est placé directement derrière la zone de détection (110).

11. Système selon les revendications 1 à 5, **caractérisé en ce que** le rapport des longueurs des canaux de sortie est de 1:3.

12. Système selon la revendication 11, **caractérisé en ce que** le module de tri est choisi dans le groupe comprenant un trieur diélectrophorétique, 'push-pull', optique ou acoustique, de préférence trieur optique.
